# EUROPEAN PATENT APPLICATION

(11) **EP 2 562 230 A1**
(43) Date of publication of application: **27.02.2013**
(21) Application number: 11771863.5
(22) Date of filing: 05.04.2011
(51) Int. Cl.: C09K 11/64, C09K 11/59, C09K 11/62, C09K 11/79, C09K 11/80, H01L 33/50

(54) **RED-TYPE LIGHT EMITTING PHOSPHOR, METHOD FOR PRODUCING SAME AND LIGHT EMITTING DEVICE USING RED-TYPE LIGHT EMITTING PHOSPHOR**

(30) Priority: 19.04.2010 JP 2010095926
(71) Applicant: Sharp Kabushiki Kaisha, Osaka-shi, Osaka 545-8522 (JP)
(72) Inventor: HARADA, Masamichi, Osaka-shi Osaka 545-8522 (JP); UEMURA, Toyonori, Osaka-shi Osaka 545-8522 (JP); FUKUNAGA, Hiroshi, Osaka-shi Osaka 545-8522 (JP); MATSUSHITA, Hitoshi, Osaka-shi Osaka 545-8522 (JP); TERASHIMA, Kenji, Osaka-shi Osaka 545-8522 (JP)
(74) Representative: Müller - Hoffmann & Partner
(86) International application number: PCT/JP2011/058597
(87) International publication number: WO 2011/132526

(57) **Abstract**

The present invention relates to a divalent europium-activated nitride red light emitting phosphor substantially represented by a general formula: (MI₁₋ₓEuₓ)MIlSiN₃ (1) (in the formula (1), MI is an alkaline-earth metal element and represents at least one element selected from the group consisting of Mg, Ca, Sr, and Ba; MII is a trivalent metal element and represents at least one element selected from the group consisting of Al, Ga, In, Sc, Y, La, Gd, and Lu; and x is the number satisfying 0.001 ≤x ≤ 0.10), in which the electrical conductivity of a supernatant liquid of the solution containing 10 parts by mass of pure water with respect to 1 part by mass of the red light emitting phosphor is not more than 10 mS/cm.

## Description

### TECHNICAL FIELD

The present invention relates to a phosphor suitable for a light emitting apparatus, and a light emitting apparatus employing the phosphor in a light converter, and particularly to a light emitting apparatus having stable characteristics.

### BACKGROUND ART

A light emitting apparatus using a combination of a light emitting element and a phosphor attracts attention as a next generation light emitting apparatus expected to realize low power consumption, compact size, high intensity, high color gamut, and high color rendition, and is now actively researched and developed. Primary light emitted from a light emitting element in a range from the longer ultraviolet to the visible blue, i.e. 380 to 480 nm, is usually used. A light converter employing various phosphors suitable for this application is also proposed.

At present, for the above-described type of a white light emitting apparatus, a combination of a light emitting element emitting blue light (peak wavelength: around 460 nm) and a trivalent cerium-activated (Y, Gd)₃(Al, Ga)₅O₁₂ phosphor or a divalent europium-activated 2(Sr, Ba)O·SiO₂ phosphor, which is excited by blue color and emits yellow light, is mainly used. In such a light emitting apparatus, however, color gamut (NTSC ratio) is about 70%, and higher color gamut has recently been required also in compact LCDs.

Furthermore, the general color rendering index (Ra) is also within the range of 60 to 70. Thus, it is required to achieve an excellent general color rendering index (Ra) in the present circumstances where color senses are generally developed.

For these technical problems, it is known that the use of a divalent europium-activated nitride red light emitting phosphor substantially represented by (MI, Eu)MIISiN₃ (MI represents at least one element selected from Mg, Ca, Sr, and Ba; and MII represents at least one element selected from Al, Ga, In, Sc, Y, La, Gd, and Lu) results in a light emitting apparatus having excellent color gamut (NTSC ratio) and color rendition.

However, in the manufacturing process, the divalent europium-activated nitride red light emitting phosphor tends to generate a by-product formed of elements in a ratio deviated from a prescribed ratio. Particularly, a by-product considered to be water soluble is produced that contains excessive MI₃N₂ and MIIN. When the divalent europium-activated nitride red light emitting phosphor is incorporated in the light emitting apparatus in the state where this by-product remains in the (MI, Eu)MIISiN₃ crystal, there occurs a technical problem that the brightness of this divalent europium-activated nitride red light emitting phosphor is significantly lowered during the operation at a high temperature and a high humidity.

In light of such circumstances, it is imperative to suppress production of a by-product, particularly a by-product containing excessive MI₃N₂ and MIIN and considered to be water soluble, in the manufacturing process of a divalent europium-activated nitride red light emitting phosphor.

For example, Japanese Patent Laying-Open No. 2005-255895 (PTL 1) discloses that a reactant is cleaned with a solvent that dissolves inorganic compounds in order to reduce the content of these inorganic compounds (by-product) contained in the reactant obtained by firing of a β-type SIALON. Examples of such a solvent include water, ethanol, sulfuric acid, hydrofluoric acid, and a mixture of sulfuric acid and hydrofluoric acid. PTL 1, however, fails to specifically disclose the effect of removing inorganic compounds by acid treatment.

Furthermore, Japanese Patent Laying-Open No. 2006-89547 (PTL 2) also discloses that the acid treatment similar to that as described above is employed to reduce the by-product such as a glass phase contained in the product. PTL 2, however, fails to specifically disclose the effect of removing the glass phase and the like by acid treatment.

### CITATION LIST

### PATENT LITERATURE

PTL 1: Japanese Patent Laying-Open No. 2005-255895
PTL 2: Japanese Patent Laying-Open No. 2006-89547

### SUMMARY OF INVENTION

### TECHNICAL PROBLEM

The present invention has been made to solve the above-described problems. An object of the present invention is to provide a divalent europium-activated nitride red light emitting phosphor that is excellent in initial brightness and improved in life property, and to provide a light emitting apparatus employing this red light emitting phosphor.

### SOLUTION TO PROBLEM

The present invention provides a divalent europium-activated nitride red light emitting phosphor substantially represented by

a general formula: (MI₁₋ₓEuₓ)MIISiN₃ (1)

(in the formula (1), MI is an alkaline-earth metal element and represents at least one element selected from the group consisting of Mg, Ca, Sr, and Ba; MII is a trivalent metal element and represents at least one element selected from the group consisting of Al, Ga, In, Sc, Y, La, Gd, and Lu; and x is a number satisfying 0.001 ≤ x ≤ 0.10). Electrical conductivity of a supernatant liquid of a solution containing 10 parts by mass of pure water with respect to 1 part by mass of the red light emitting phosphor is not more than 10 mS/cm.

Preferably, in the red light emitting phosphor according to the present invention, in the general formula (1), MII is at least one element selected from the group consisting of Al, Ga and In.

The present invention provides a light emitting apparatus including a light emitting element of a gallium nitride-based semiconductor emitting primary light having a peak wavelength of 430 to 480 nm, and a light converter absorbing a part of the primary light and emitting secondary light having a wavelength longer than a wavelength of the primary light. The light converter is a divalent europium-activated nitride red light emitting phosphor substantially represented by

a general formula: (MI₁₋ₓEuₓ)MIISiN₃ (1)

(in the formula (1), MI is an alkaline-earth metal element and represents at least one element selected from the group consisting of Mg, Ca, Sr, and Ba; MII is a trivalent metal element and represents at least one element selected from the group consisting of Al, Ga, In, Sc, Y, La, Gd, and Lu; and x is a number satisfying 0.001 ≤ x ≤ 0.10). Electrical conductivity of a supernatant liquid of a solution containing 10 parts by mass of pure water with respect to 1 part by mass of the red light emitting phosphor is not more than 10 mS/cm.

Preferably, in the light emitting apparatus according to the present invention, in the general formula (1), MII is at least one element selected from the group consisting of Al, Ga and In.

Preferably, in the light emitting apparatus according to the present invention, the light converter includes a divalent europium-activated oxynitride green light emitting phosphor which is a β-type SIALON substantially represented by

a general formula: EuₐSi_{b}Al_{c}O_{d}Nₑ (2)

(in the formula (2), a, b, c, d, and e are numbers satisfying 0.005 ≤ a ≤ 0.4, b + c = 12, and d + e = 16).

Preferably, in the light emitting apparatus according to the present invention, the light converter includes at least one of a trivalent cerium-activated silicate green light emitting phosphor substantially represented by

a general formula: MIII₃(MIV_{1-f}Ce_{f})₂(SiO₄)₃ (3)

(in the formula (3), MIII represents at least one element selected from the group consisting of Mg, Ca, Sr, and Ba; MIV represents at least one element selected from the group consisting of Al, Ga, In, Sc, Y, La, Gd, and Lu; and f is a number satisfying 0.005 < f ≤0.5), and a trivalent cerium-activated oxoate green light emitting phosphor substantially represented by

a general formula: MIII(MIV_{1-f}Ce_{f})₂O₄ (4)

(in the formula (4), MIII represents at least one element selected from the group consisting of Mg, Ca, Sr, and Ba; MIV represents at least one element selected from the group consisting of Al, Ga, In, Sc, Y, La, Gd, and Lu; and f is a number satisfying 0.005 ≤ f ≤ 0.5).

Preferably, in the light emitting apparatus according to the present invention, in the formula (3) or (4), MIV is at least one element of Sc and Y.

Preferably, in the light emitting apparatus according to the present invention, the light converter includes at least one of a divalent europium-activated silicate green light emitting phosphor or yellow light emitting phosphor substantially represented by

a general formula: 2(MV_{1-g}Eu_{g})O·SiO₂ (5)

(in the formula (5), MV represents at least one element selected from the group consisting of Mg, Ca, Sr, and Ba; and g is a number satisfying 0.005 ≤ g ≤ 0.10), and a trivalent cerium-activated aluminate green light emitting phosphor or yellow light emitting phosphor substantially represented by

a general formula: (MVI₁₋ₕCeₕ)₃Al₅O₁₂ (6)

(in the formula (6), MVI represents at least one element selected from the group consisting of Y, Gd and Lu; and h is a number satisfying 0.005 ≤ h ≤ 0.5).

Preferably, in the light emitting apparatus according to the present invention, in the formula (5), MV is at least one element of Sr and Ba.

The present invention provides a method for manufacturing a phosphor, characterized by controlling a value of electrical conductivity of a supernatant liquid of a solution containing a phosphor and pure water to be not more than a prescribed value.

The present invention provides a method for manufacturing a phosphor, including the steps of: preparing a phosphor; and cleaning the phosphor using acid and pure water. The cleaning step is performed until a value of electrical conductivity of a supernatant liquid of a solution containing the phosphor and pure water is not more than a prescribed value.

### ADVANTAGEOUS EFFECTS OF INVENTION

According to the present invention, it is possible to provide a divalent europium-activated nitride red light emitting phosphor that is excellent in initial brightness and improved in life property. Also, by using the red light emitting phosphor, it is possible to provide a light emitting apparatus capable of achieving white light that is excellent in initial brightness, less in brightness reduction, less in chromaticity variations, and improved in life property.

### BRIEF DESCRIPTION OF DRAWINGS

Fig. 1 is a schematic cross-sectional view showing a light emitting apparatus in one embodiment of the present invention.
Fig. 2 is a schematic cross-sectional view showing a light emitting apparatus in one embodiment of the present invention.

### DESCRIPTION OF EMBODIMENTS

### <Europium-Activated Nitride Red Light Emitting Phosphor>

In one embodiment of the present invention, a phosphor is a divalent europium-activated nitride red light emitting phosphor substantially represented by the following general formula (1).

General formula: (MI₁₋ₓEuₓ)MIISiN₃ (1)

In the above formula (1), MI represents at least one alkaline-earth metal element selected from the group consisting of Mg, Ca, Sr, and Ba. Also in the above formula (1), MII is a trivalent metal element and is at least one element selected from the group consisting of Al, Ga, In, Sc, Y, La, Gd, and Lu. Particularly, it is preferable that MII is at least one element selected from the group consisting of Al, Ga and In since it can emit red light much more efficiently. In the above formula (1), the value of "x" is 0.001 ≤ x ≤ 0.10. When the value of "x" is less than 0.001, inconveniently, sufficient brightness cannot be achieved. Furthermore, when the value of "x" exceeds 0.10, inconveniently, brightness greatly decreases due to concentration quenching and the like. In terms of stability of the characteristic and host crystal homogeneity, it is preferable that the value of "x" in the above formula (1) is 0.005 ≤ x ≤ 0.05.

Furthermore, in the solution containing 10 parts by mass of pure water with respect to 1 part by mass of the divalent europium-activated nitride red light emitting phosphor represented by the above general formula (1), the electrical conductivity of the supernatant liquid is not more than 10 mS/cm. When the electrical conductivity exceeds 10 mS/cm, the water-soluble by-product contained in the above-mentioned red light emitting phosphor causes a significant adverse effect on the above-mentioned red light emitting phosphor. Accordingly, when the above-mentioned red light emitting phosphor is incorporated in the light emitting apparatus, the brightness and the life property of each of the above-mentioned phosphor and light emitting apparatus significantly deteriorate.

Examples of the divalent europium-activated nitride red light emitting phosphor substantially represented by the above formula (1) may specifically include, but of course are not limited to, (Ca_{0.99}Eu_{0.01})SiAlN₃, (Ca_{0.97}Mg_{0.02}Eu_{0.01})(Al_{0.99}Ga_{0.01})SiN₃, (Ca_{0.98}EU_{0.02})AlSiN₃, (Ca_{0.58}Sr_{0.40}Eu_{0.02})(Al₀.₉₈In_{0.02})SiN₃, (Ca_{0.999}Eu_{0.00})AlSiN₃, (Ca_{0.895}Sr_{0.100}Eu_{0.005})AlSiN₃, (Ca_{0.79}Sr_{0.20}Eu_{0.0})AlSiN₃, (Ca_{0.98}Eu_{0.02})(Al_{0.02}Ga_{0.05})SiN₃, (Ca_{0.20}Sr_{0.79}Eu_{0.01}AlSiN₃, and the like.

In addition, the electrical conductivity was measured using a commercially available electric conductivity meter (YOKOGAWA: SC72-21JAA).

The red light emitting phosphor of the present invention can be fabricated by the conventionally known appropriate method. For example, the following operation can be employed to achieve the red light emitting phosphor in which the electrical conductivity of the supernatant liquid is not more than 10 mS/cm in the solution containing 10 parts by mass of pure water with respect to 1 part by mass of the red light emitting phosphor. Specifically, 100g of pure water, 1g of 96% concentrated sulfuric acid (H₂SO₄) and 1g of 46% hydrofluoric acid (HF) are added to 10g of red light emitting phosphor, which is then adjusted at a temperature of 50 °C and stirred for 20 minutes. Then, the red light emitting phosphor is precipitated to remove the supernatant liquid. This operation is repeated three times. Then, 100g of pure water is added to the red light emitting phosphors, which is then adjusted at a temperature of 80 °C and stirred for 20 minutes. Then, the red light emitting phosphor is precipitated to remove the supernatant liquid. This operation is repeated ten times. Finally, the red light emitting phosphor is precipitated and the electrical conductivity of the supernatant liquid is measured at ordinary temperature.

The above-described operation normally results in the electrical conductivity of 10 mS/cm or less. However, if the above-described operation does not result in the electrical conductivity of 10 mS/cm or less, it is preferable to further raise the temperature during cleaning with pure water. The temperature during cleaning with pure water can be set at around 100 °C, for example. Furthermore, it is also preferable to add 100g of pure water and 2g of 60% concentrated nitric acid (HNO₃) to 10g of red light emitting phosphor, which is then adjusted at a temperature of 80 °C and stirred for 20 minutes. This operation may be repeated three times. The above-described operation is however not limited thereto.

### <Light Emitting Apparatus>

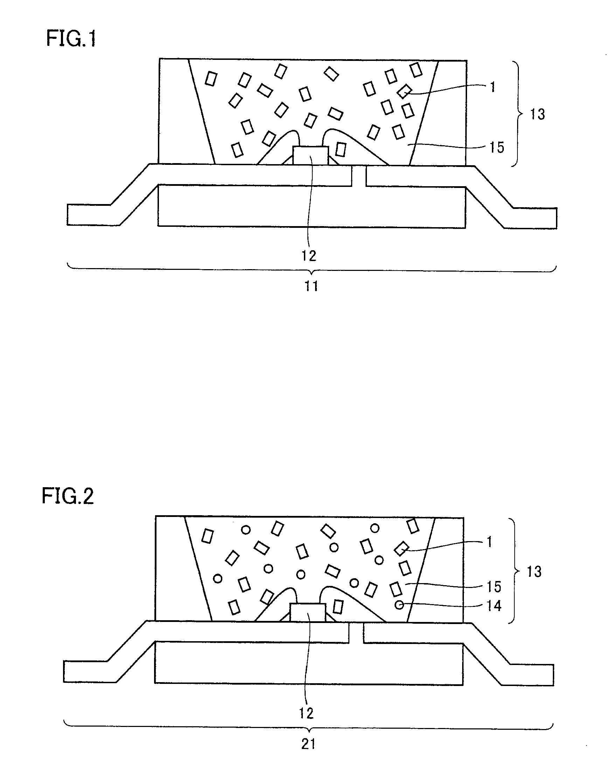

The present invention provides a light emitting apparatus employing a divalent europium-activated nitride red light emitting phosphor of the present invention as described above. Specifically, in one embodiment of the present invention, the light emitting apparatus basically includes a light emitting element emitting primary light, and a light converter absorbing a part of the above-mentioned primary light and emitting secondary light having a wavelength equal to or longer than the wavelength of the primary light. The above-mentioned light converter includes a red light emitting phosphor of the present invention as described above. Fig. 1 is a cross-sectional view schematically showing a light emitting apparatus 11 in one embodiment of the present invention. Light emitting apparatus 11 shown as an example in Fig. 1 basically includes a light emitting element 12 and a light converter 13 that includes a plurality of phosphor particles 1. Phosphor particles 1 is made of a divalent europium-activated nitride red light emitting phosphor of the present invention.

In one embodiment of the present invention, the light emitting apparatus is provided with a light converter including the red light emitting phosphor of the present invention. Such a light emitting apparatus can efficiently absorb the primary light from the light emitting element to yield white light having highly-efficient and excellent color gamut (NTSC ratio), excellent color rendering property and excellent life property.

In light emitting apparatus 11 shown in Fig. 1, a medium 15 of light converter 13 is not specifically limited as long as light converter 13 contains the red light emitting phosphor of the present invention and can absorb a part of primary light emitted from light emitting element 12 and emit secondary light having a wavelength equal to or longer than that of the primary light. For example, transparent resin such as epoxy resin, silicone resin, urea resin, or the like may be used as a medium 15, although the present invention is not limited thereto. Light converter 13 may contain any appropriate additive such as SiO₂, TiO₂, ZrO₂, Al₂O₃, Y₂O₃, as a matter of course, to such an extent that the effect of the present invention is not inhibited.

A gallium nitride (GaN)-based semiconductor is used for light emitting element 12 employed in light emitting apparatus 11, in terms of efficiency. Light emitting element 12 to be employed in light emitting apparatus 11 emits primary light having a peak wavelength in the range of 430 to 480 nm. It is not preferable to use a light emitting element having a peak wavelength of less than 430 nm since it reduces contribution of blue component, worsens color rendition, and thus is not practical. It is also not preferable to use a light emitting element having a peak wavelength of greater than 480 nm since it reduces brightness of white and thus is not practical. In terms of efficiency, light emitting element 12 in light emitting apparatus 11 of the present invention preferably emits primary light in the range of 440 to 470 nm.

In one embodiment of the present invention, light converter 13 of light emitting apparatus 11 may include phosphor particles 14 other than the above-mentioned red light emitting phosphor of the present invention, as shown in Fig. 2, as a matter of course. As phosphor particles that may be included in light converter 13, other than the red light emitting phosphor of the present invention, it is suitable to employ a green light emitting phosphor or a yellow light emitting phosphor, considering that a light emitting apparatus presenting white light by mixing with a red light emitting phosphor of the present invention can be realized.

In one embodiment of the present invention, the divalent europium-activated oxynitride green light emitting phosphor which is a β-type SIALON represented by the following general formula (2) is suitable for a green light emitting phosphor.

General formula: EuₐSi_{b}Al_{c}O_{d}Nₑ (2)

In the above formula (2), the value of "a" is 0.005 ≤ a ≤ 0.4, b + c = 12, and d + e = 16. In the above formula (2), if the value of "a" is less than 0.005, inconveniently, sufficient brightness cannot be obtained, and if the value of "a" exceeds 0.4, inconveniently, brightness significantly decreases due to concentration quenching and the like. In terms of stability of the characteristic and host crystal homogeneity, the value of "a" in the above formula (2) is preferably 0.01 ≤ a ≤ 0.2.

Specifically, examples of the divalent europium-activated oxynitride green light emitting phosphor which is a β-type SIALON represented by the above formula (2) may include, but of course are not limited to, Eu_{0.5}Si_{11.50} Al_{0.50}O_{0.30}N_{15.70}, Eu_{0.10}Si_{11.00}Al_{1.00}O_{0.40}N_{15.60}, Eu_{0.30}Si_{9.80}Al_{2.20}O_{1.00}N_{15.00}, Eu_{0.15}Si_{10.00}Al_{2.002}O_{0.50}N_{15.50}, EU_{0.01}Si_{11.60}Al_{0.40}O_{0.20}N_{15.80}, Eu_{0.005}Si_{11.70}Al_{0.30}O_{0.15}N_{15.85}, Eu_{0.25}Si_{11.65}Al_{0.35}N_{15.70}, Eu_{0.40}Si_{11.35}Al_{0.65}O_{0.35}N_{15.65}, and the like.

When the above-described divalent europium-activated oxynitride green light emitting phosphor is used, the mixture ratio to the red light emitting phosphor of the present invention in light converter 13 is not particularly limited, but it is preferable to set the green light emitting phosphor to fall within a range of 99% by mass to 65% by mass, and more preferably 95% by mass to 75% by mass, in mass ratio with respect to the total amount of the red light emitting phosphor of the present invention.

In addition to the above-described divalent europium-activated oxynitride green light emitting phosphor and the red light emitting phosphor of the present invention, light converter 13 in light emitting apparatus 11 may further include other phosphor particles, to such an extent that the effect of the present invention is not inhibited.

Light emitting apparatus 11 can be manufactured by the conventionally known appropriate technique and the manufacturing method thereof is not particular limited. For example, the manufacturing method may be exemplified by which a sealing material made of thermosetting silicone resin as a medium is used, to which the red light emitting phosphor of the present invention (and a phosphor other than the red light emitting phosphor of the present invention, as necessary) is mixed to seal and form light emitting element 12 therein.

In one embodiment of the present invention, the trivalent cerium-activated silicate green light emitting phosphor represented by the following general formula (3) is suitable for a green light emitting phosphor.

General formula: MIII₃(MIV_{1-f}C_{f})₂(SiO₄)₃ (3)

In the above formula (3), MIII is at least one element selected from the group consisting of Mg, Ca, Sr, and Ba. MIV is at least one element selected from the group consisting of Al, Ga, In, Sc, Y, La, Gd, and Lu. Among them, MIV is preferably at least one element of Sc and Y. The value of "f" is 0.005 ≤ f ≤ 0.5. In the above formula (3), if the value of "f" is less than 0.005, inconveniently, sufficient brightness cannot be obtained, and if the value of "f" exceeds 0.5, inconveniently, brightness significantly decreases due to concentration quenching and the like. In terms of stability of the characteristic and host crystal homogeneity, the value of "f" in the above formula is preferably 0.01 ≤ f ≤ 0.2.

Specifically, examples of the trivalent cerium-activated silicate green light emitting phosphor substantially represented by the above formula (3) may include, but of course are not limited to, Ca₃(SC₀₋₈₅Ce_{0.15})₂(SiO₄)₃, (Ca_{0.8}M_{g0.2})₃(SC_{0.89}Y_{0.01}Ce_{0.10})₂(SiO₄)₃, (Ca_{0.99}Mg_{0.01})₃(Sc_{0.95}Ce_{0.05})₂(SiO₄)₃, (Ca_{0.999}Mg_{0.001})₃(Sc_{0.965}Y_{0.005}Ce_{0.03})₂(SiO₄)₃, (Ca_{0.90}Mg_{0.10})₃(Sc_{0.95}Ce₀₋₀₅)₂(SiO₄)₃, Ca₃(SC_{0.95}Ce_{0.05})₂(SiO₄)₃, and the like.

In one embodiment of the present invention, the trivalent cerium-activated oxoate green light emitting phosphor represented by the following general formula (4) is suitable for a green light emitting phosphor.

General formula: MIII(MIV_{1-f}Ce_{f})₂O₄ (4)

In the above formula (4), MIII is at least one element selected from the group consisting of Mg, Ca, Sr, and Ba. MIV is at least one element selected from the group consisting of Al, Ga, In, Sc, Y, La, Gd, and Lu. Among them, MIV is preferably at least one element of Sc and Y. The value of "f" is 0.005 ≤ f ≤ 0.5. In the above formula (4), if the value of "f" is less than 0.005, inconveniently, sufficient brightness cannot be obtained, and if the value of "f" exceeds 0.5, inconveniently, brightness significantly decreases due to concentration quenching and the like. In terms of stability of the characteristic and host crystal homogeneity, the value of "f" in the above formula is preferably 0.01 ≤ f ≤ 0.2.

Specifically, examples of the trivalent cerium-activated oxoate green light emitting phosphor substantially represented by the above formula (4) may include, but of course are not limited to, Ca(Sc_{0.85}Ce_{0.85}Ce_{0.15})₂O₄, (Ca_{0.8}Mg_{0.2})(Sc_{0.89}Ye_{0.10})₂O₄, (Ca_{0.99}Mg_{0.01})(SC_{0.95}Ce_{0.05})₂O₄, (Ca_{0.999}Mg_{0.001})(Sc_{0.965}Y_{0.005}Ce_{0.03}) ₂O₄, (Ca_{0.90}Mg_{0.10})(SC _{0.95}Ce_{0.05})₂O, Ca(Sc_{0.95}Ce_{0.05})₂O₄, and the like.

In one embodiment of the present invention, the divalent europium-activated silicate green light emitting phosphor or yellow light emitting phosphor represented by the following general formula (5) is suitable for a green light emitting phosphor or a yellow light emitting phosphor.

General formula: 2(MV_{1-g}Eu_{g})O·SiO₂ (5)

In the above formula (5), MV is at least one element selected from the group consisting of Mg, Ca, Sr, and Ba. Among them, MV is preferably at least one element of Sr and Ba. The value of "g" is 0.005 ≤ g ≤ 0.10. In the above formula (5), if the value of "g" is less than 0.005, inconveniently, sufficient brightness cannot be obtained, and if the value of "g" exceeds 0.10, inconveniently, brightness significantly decreases due to concentration quenching and the like. In terms of stability of the characteristic and host crystal homogeneity, the value of "g" in the above formula is preferably 0.01 ≤ g ≤ 0.08.

Specifically, examples of the divalent europium-activated silicate green light emitting phosphor or yellow light emitting phosphor substantially represented by the above formula may include, but of course are not limited to, 2(Sr_{0.70}Ba_{0.25}Eu_{0.05})O·SiO₂, 2(Sr_{0.85}Ba_{0.10}Eu_{0.05})O·SiO₂, 2(Sr_{0.40}Ba_{0.59}Eu_{0.01})O·SiO₂, 2(Sr_{0.55}Ba_{0.40}Eu_{0.05})O·SiO₂, 2(Sr_{0.44}Ba_{0.52}Ca_{0.01}Eu₀.₀₃)O·SiO₂, 2(Sr_{0.50}Ba_{0.48}Mg_{0.01}Eu_{0.01})O·SiO₂, 2(Sr_{0.44}Ba_{0.50}Eu_{0.06})O·SiO₂, 2(Sr_{0.780}Ba_{0.215}Eu_{0.005})O·SiO₂, 2(Sr_{0.52}Ba_{0.40}Eu_{0.08})O·SiO₂, 2(Sr_{0.51}Ba_{0.45}Eu_{0.04})O·SiO₂, 2(Sr_{0.75}Ba_{0.20}Eu_{0.05})O·SiO₂, and the like.

In one embodiment of the present invention, the trivalent cerium-activated aluminate green light emitting phosphor or yellow light emitting phosphor represented by the following general formula (6) is suitable for a green or yellow light emitting phosphor.

General formula: (MVI₁₋ₕCeₕ)₃Al₅O₁₂ (6)

In the above formula (6), MVI is at least one element selected from the group consisting of Y, Gd and Lu. The value of "h" is 0.005 ≤ h ≤ 0.5. In the above formula (6), if the value of "h" is less than 0.005, inconveniently, sufficient brightness cannot be obtained, and if the value of "h" exceeds 0.5, inconveniently, brightness significantly decreases due to concentration quenching and the like. In terms of stability of the characteristic and host crystal homogeneity, the value of "h" in the above formula is preferably 0.01 ≤ h ≤ 0.2.

Specifically, examples of the trivalent cerium-activated aluminate green or yellow light emitting phosphor substantially represented by the above formula may include, but of course are not limited to, (Y_{0.52}Gd_{0.36}Ce_{0.12})₃Al₅O₁₂, (Y_{0.85}Gd_{0.10}Ce_{0.05})₃Al₅O₁₂, (Y_{0.40}Gd_{0.50}Ce_{0.10})₃Al₅O₁₂, (Y_{0.99}Ce_{0.01})₃Al₅O₁₂, (Y_{0.695}Gd_{0.30}Ce_{0.005})₃Al₅O₁₂, (Y_{0.35}Gd_{0.63}Ce_{0.02})₃Al₅O₁₂, (Y_{0.40}Gd_{0.45}Ce_{0.15})₃Al₅O₁₂, (Y_{0.60}Gd_{0.35}Ce_{0.05})₃Al₅O₁₂, (Y_{0.64}Gd_{0.35}Ce_{0.01})₃Al₅O₁₂, and the like.

Although the present invention will be hereinafter described in greater detail with reference to Examples and Comparative Examples, the present invention is not limited thereto.

### Examples

### <Evaluation of Divalent Europium-Activated Nitride Red Light Emitting Phosphor>

### (Example 1, Comparative Example 1)

Example 1: 100g of pure water, 1g of 96% concentrated sulfuric acid (H₂SO₄) and 1g of 46% hydrofluoric acid (HF) were added to 10g of divalent europium-activated nitride red light emitting phosphor (Ca_{0.99}Eu_{0.01})AlSiN₃, which was then adjusted at a temperature of 50 °C and stirred for 20 minutes. Then, the red light emitting phosphor was precipitated to remove the supernatant liquid. This operation was repeated three times. Then, 100g of pure water was added to the red light emitting phosphor, which was then adjusted at a temperature of 80 °C and stirred for 20 minutes. Then, the red light emitting phosphor was precipitated to remove the supernatant liquid. This operation was repeated ten times. Finally, the red light emitting phosphor was precipitated, and the electrical conductivity of the supernatant liquid was measured at ordinary temperature, which was 10 µS/cm.

The divalent europium-activated nitride red light emitting phosphor (Ca_{0.99}Eu_{0.01})AlSiN₃ subjected to the cleaning operation as described above was then supplied to the cell of the spectrophotofluorometer. Then, the initial luminance was evaluated by the spectrophotofluorometer. As to the initial luminance, the above-mentioned red light emitting phosphor was excited by blue light in 450 nm to measure the peak height of red light emission. Then, the cell was left in the thermostatic bath with a relative humidity of 85% at a temperature of 85 °C for 2000 hours. After a lapse of 2000 hours, the peak height of red light emission of the above-mentioned red light emitting phosphor was measured by the same method as that in the case of the initial luminance. In addition, the spectrophotofluorometer (F-2500) manufactured by Hitachi, Ltd. was used in this case.

Comparative Example 1: The same cleaning operation as that in Example 1 was repeated until, similarly to Example 1, the electrical conductivity of the supernatant liquid of the solution containing 10 parts by mass of pure water with respect to 1 part by mass of phosphor reached 100 mS/cm.

The luminance was evaluated in the same manner as in Example 1 using the divalent europium-activated nitride red light emitting phosphor (Ca_{0.99}Eu_{0.01})AlSiN₃ obtained by the above-described operation.

The results thereof are shown in Table 1.

**[Table 1]**

| | Initial Luminance | Luminance after Lapse of 2000 Hours |
|---|---|---|
| Example 1 | 100.0% | 99.9% |
| Comparative Example 1 | 97.0% | 73.1% |

As can be seen from Table 1, the red light emitting phosphor in Example 1 was excellent in initial brightness and also excellent in luminance after a lapse of 2000 hours as compared with Comparative Example 1, which resulted in tremendous improvement in life property.

### (Examples 2 to 6, Comparative Examples 2 to 6)

As to the divalent europium-activated nitride red light emitting phosphor, Table 2 shows the results of evaluation of the samples having various compositions and electrical conductivities in the same manner as in Example 1.

**[Table 2]**

| | Composition | Electrical Conductivity | Initial Luminance | Luminance after Lapse of 2000 Hours |
|---|---|---|---|---|
| Example 2 | (Ca_{0.58}Sr_{0.40}Eu_{0.02})(Al_{0.58}Sr_{0.08}In_{0.02})SiN₃ | 10µS/cm | 100.0% | 100.1% |
| Comparative Example 2 | (Ca_{0.58}Sr_{0.40}Eu_{0.02})(Al_{0.98})₀.₉₈I_{n0.02})SiN₃ | 250 mS/cm | 95.6% | 68.4% |
| Example 3 | (Ca_{0.20}Sr_{0.79}Eu_{0.01})AlSiN₃ | 100 µS/cm | 100.0% | 99.8% |
| Comparative Example 3 | (Ca_{0.20}Sr_{0.79}Eu_{0.01})AlSiN₃ | 150 mS/cm | 96.6% | 69.6% |
| Example 4 | (Ca_{0.895}Sr_{0.100}Eu_{0.005})AlSiN₃ | 1 mS/cm | 100.0% | 99.3% |
| Comparative Example 4 | (Ca_{0.895} Sr_{0.100}Eu_{0.005})AlSiN₃ | 200 mS/cm | 97.9% | 72.0% |
| Example 5 | (Ca_{0.98}Eu_{0.02})(AlogsGa_{0.05})SiN₃ | 5 mS/cm | 100.0% | 99.0% |
| Comparative Example 5 | (Ca_{0.98}Eu_{0.02})(Al_{0.95}Ga_{0.05})SiN₃ | 100 mS/cm | 98.5% | 72.9% |
| Example 6 | (Ca_{0.30}Sr_{0.69}Eu_{0.01})AlSiN₃ | 10 µS/cm | 100.0% | 99.9% |
| Comparative Example 6 | (Ca_{0.30}Sr_{0.69}Eu_{0.01})AlSiN₃ | 200 mS/cm | 95.9% | 70.8% |

As can be seen from Table 2, the red light emitting phosphors in Examples 2 to 6 were excellent in initial brightness and also excellent in luminance after a lapse of 2000 hours as compared with Comparative Examples 2 to 6, which resulted in tremendous improvement in life property.

### <Evaluation of Light Emitting Apparatus>

### (Example 7, Comparative Example 7)

Example 7: A gallium nitride (GaN)-based semiconductor having a peak wavelength of 450 nm was used as a light emitting element. A light converter was produced by using, as a red light emitting phosphor, a divalent europium-activated nitride phosphor (Ca_{0.99}Eu_{0.01})AlSiN₃ in which the electrical conductivity of the supernatant liquid of the solution containing 10 parts by mass of pure water with respect to 1 part by mass of phosphor is 20 µS/cm, and as a green light emitting phosphor, a green light emitting phosphor having a composition of Eu_{0.05}Si_{11.55}Al_{0.45}O_{0.35}N_{15.65} (β-type SIALON). These red light emitting phosphor and green light emitting phosphor were mixed in a proportion of 1:2.7 in mass ratio, which were then dispersed in the sealing material made of thermosetting silicone resin as a medium, in which the light emitting element is sealed to produce a light converter. Thus, a light emitting apparatus of Example 7 was fabricated. Then, the initial brightness and the chromaticity (x, y) of the light emitting apparatus of Example 7 fabricated in this way were measured. Then, the light emitting apparatus was turned on continuously for 2000 hours at a forward current (IF) of 30mA in the thermostatic bath with a relative humidity of 85% at a temperature of 85 °C. Then, the brightness and the chromaticity (x, y) of the light emitting apparatus after a lapse of 2000 hours were measured.

In addition, the brightness was measured by turning on the light emitting apparatus at a forward current (IF) of 20 mA and measuring optical power (photocurrent) from the light emitting apparatus.

Furthermore, the value of the chromaticity (x, y) was calculated by turning on the light emitting apparatus at a forward current (IF) of 20mA and measuring the white light from the light emitting apparatus by MCPD-2000 manufactured by Otsuka electronics Co., Ltd.

Comparative Example 7: A light emitting apparatus of Comparative Example 7 was fabricated and its characteristics were similarly evaluated in the same manner as in Example 7, except for using the divalent europium-activated nitride red light emitting phosphor (Ca_{0.99}Eu_{0.01})AlSiN₃ in which the electrical conductivity of the supernatant liquid of the solution containing 10 parts by mass of pure water with respect to 1 part by mass of phosphor was 100 mS/cm. The results thereof are shown in Table 3.

**[Table 3]**

| | Initial Characteristics | | | Characteristics after Lapse of 2000 Hours | | |
|---|---|---|---|---|---|---|
| | Brightness | x | y | Brightness | Variations in x value | Variations in y value |
| Example 7 | 100.0% | 0.290 | 0.260 | 99.4% | -0.001 | -0.002 |
| Comparative Example 7 | 98.6% | 0.290 | 0.259 | 94.6% | -0.025 | +0.002 |

As can be seen from Table 3, the light emitting apparatus of Example 7 was excellent in initial brightness, and less in brightness reduction and chromaticity variations as compared with Comparative Example 7, which resulted in tremendous improvement in life property.

### (Examples 8 to 18, Comparative Examples 8 to 18)

Light emitting apparatuses were fabricated in the same manner as in Example 7 using a combination of various phosphors. The results of evaluation of the characteristics are shown in Tables 4 and 5.

**[Table 4]**

| | Phosphor | Electrical Conductivity (Red Light Emitting Phosphor) | Light Emitting Element | Initial Characteristics | | | Characteristics after Lapse of 2000 Hours | | |
|---|---|---|---|---|---|---|---|---|---|
| | | | | Brightness | x | y | Brightness | Variations in x value | Variations in y value |
| Example 8 | Green: Eu_{0.10}Si_{11.00}Al_{0.00}N_{15.60} Red: (Ca_{0.58}Sr_{0.40}Eu_{0.02})Al_{0.98}In_{0.02})SiN₃ | 10 µS/cm | 460 nm | 100.0% | 0.280 | 0.271 | 99.6% | -0.002 | -0.002 |
| Comparative Example 8 | Green : Eu_{0.10}Si_{11.00}O_{0.40}N_{15.60} Red: (Ca_{0.58}Sr_{0.40}Eu_{0.02})(Al_{0.98}In_{0.02})SiN₃ | 250 mS/cm | 460 nm | 98.1% | 0.280 | 0.270 | 94.1% | -0.026 | +0.003 |
| Example 9 | Green: (Ca_{0.99}Mg_{0.01})₃(Sc_{0.95} )₂(SiO₄)₃ Red: (Ca_{0.30}Sr_{0.69}Eu_{0.01})AlSiN₃ | 10 µS/cm | 440 nm | 100.0% | 0.300 | 0.285 | 99.5% | -0.001 | -0.003 |
| Comparative Example 9 | Green: (Ca_{0.99}Mg_{0.01})₃(Se_{0.95}Ce_{0.05})₂(SiO₄)₃ Red: (Ca_{0.30}Sr_{0.69}Eu_{0.01})AlSiN₃ | 200 mS/cm | 440 nm | 98.5% | 0.301 | 0.284 | 94.6% | -0.025 | +0.001 |
| Example 10 | Green: (Ca_{0.90}Mg_{0.10})₃(Sc_{0.95}Ce_{0.05})₂(SiO₄)₃ Red: (Ca_{0.895}Sr_{0.100})Eu_{0.005})AlSiN₃ | 1 mS/cm | 455 nm | 100.0% | 0.310 | 0.300 | 99.1% | -0.003 | -0.003 |
| Comparative Example 10 | Green: (Ca_{0.90}Mg_{0.10})₃(Sc_{0.95}Ce_{0.05})₂(SiO₄)₃ Red: (Ca_{0.895}Sr_{0.1005})AlSiN₃ | 200 mS/cm | 455 nm | 98.6% | 0.311 | 0.300 | 94.7% | -0.026 | +0.001 |
| Example 11 | Green: Ca(Sc_{0.85}Ce_{0.15})₂O₄ Red: (Ca_{0.99}Eu_{0.01})AlSiN₃ | 10 µS/cm | 430 nm | 100.0% | 0.320 | 0.320 | 99.3% | -0.001 | -0.003 |
| Comparative Example 11 | Green: Ca(SC_{0.85}Ce_{0.15})₂O₄ Red: (Ca_{0.99}Eu_{0.01})AlSiN₃ | 100 mS/cm | 430 nm | 98.2% | 0.320 | 0.321 | 94.2% | -0.027 | +0.002 |
| Example 12 | Green: (Ca_{0.99}Mg_{0.01})(SC_{0.95}Ce_{0.05})₂O₄ Red: (Ca_{0.20}Sr_{0.79}Eu_{0.01} AlSiN₃ | 50 µS/cm | 480 nm | 100.0% | 0.305 | 0.310 | 99.6% | -0.001 | -0.002 |
| Comparative Example 12 | Green: (Ca_{0.99}Mg_{0.01})(Sc_{0.95}Ce_{0.05})₂O₄ Red: (Ca_{0.20}Sr_{0.79}Eu_{0.01})AlSiN₃ | 30 mS/cm | 480 nm | 98.8% | 0.306 | 0.309 | 94.8% | -0.024 | +0.002 |
| Example 13 | Yellow : 2(Sr_{0.75}Ba_{0.20}Eu_{0.05})O·SiO₂ Red: (Ca_{0.30}Sr_{0.69}Eu_{0.01})AlSiN₃ | 30 µS/cm | 475 nm | 100.0% | 0.440 | 0.410 | 99.5% | -0.002 | -0.002 |
| Comparative Example 13 | Yellow:2(Sr_{0.20}Eu_{0.05})O·SiO₂ Red: (Ca_{0.30}Sr_{0.69}Eu_{0.01})AlSiN₃ | 200 mS/cm | 475 nm | 98.0% | 0.441 | 0.410 | 94.0% | -0.029 | +0.004 |
| Example 14 | Yellow: 2(Sr_{0.70}Ba_{0.25}Eu_{0.05})O·SiO₂ Red:(Ca_{0.98}Eu_{0.02})AlSiN₃ | 5 µS/cm | 455 nm | 100.0% | 0.435 | 0.405 | 99.4% | -0.002 | -0.003 |
| Comparative Example 14 | Yellow: 2(Sr_{0.70}Bu_{0.05})O·SiO₂ Red: (Ca_{0.98}Eu_{0.02})AlSiN₃ | 150 mS/cm | 455 nm | 98.1% | 0.435 | 0.405 | 94.1% | -0.028 | +0.004 |

**[Table 5]**

| | Phosphor | Electrical Conductivity (Red Light Emitting Phosphor) | Light Emitting Element | Initial Characteristics | | | Characteristics after Lapse of 2000 Hours | | |
|---|---|---|---|---|---|---|---|---|---|
| | | | | Brightness | x | y | Brightness | Variations in x value | Variations in y value |
| Example 15 | Green:2(Sr_{0.51}Ba_{0.45}Eu_{0.04})O·SiO₂ Red : (Ca_{0.30}Sr_{0.69}Eu_{0.01})AlSiN₃ | 20 µS/cm | 445 nm | 100.0% | 0.290 | 0.275 | 99.6% | -0.001 | -0.002 |
| Comparative Example 15 | Yellow : 2(Sr_{0.51}Ba_{0.45}Eu_{0.04})O·SiO₂ Red: (Ca_{0.30}Sr_{0.69}Eu_{0.01})AlSiN₃ | 70 mS/cm | 445 nm | 98.6% | 0.291 | 0.274 | 94.3% | -0.025 | +0.003 |
| Example 16 | Yellow:(Y_{0.52}Gd_{0.36}Ce_{0.12})₃Al₅O₁₂ Red: (Ca_{0.30}Sr_{0.69} Eu_{0.01}AlSiN₃ | 30 µS/cm | 465 nm | 100.0% | 0.450 | 0.410 | 99.4% | -0.002 | -0.001 |
| Comparative Example 16 | Yellow: (Y_{0.52}Gd_{0.36}Ce_{0.12})₃Al₅O₁₂ Red: (Ca_{0.30}Sr_{0.69}Eu_{0.01})A AlSiN₃ | 250 mS/cm | 465 nm | 98.2% | 0.450 | 0.410 | 94.0% | -0.029 | +0.004 |
| Example 17 | Yellow : (Y_{0.60}Gd_{0.35}Ce_{0.05})Al₅O₁₂ Red: (Ca_{0.895}Sr_{0.100}Eu_{0.005})AlSiN₃ | 25 µS/cm | 480 nm | 100.0% | 0.465 | 0.415 | 99.6% | -0.002 | -0.003 |
| Comparative Example 17 | Yellow : (Y_{0.60}Gd_{0.35}Ce_{0.05})₃Al₅O₁₂ Red:(Ca_{0.895}Sr_{0.100}Eu_{0.05})AlSiN₃ | 100 mS/cm | 480 nm | 98.3% | 0.466 | 0.415 | 94.1% | -0.028 | +0.003 |
| Example 18 | Green : (Y_{0.99}Ce_{0.01})₃Al₅O₁₂ Red : (Ca_{0.98}Eu_{0.02})AISiN₃ | 300 µS/cm | 450 nm | 100.0% | 0.270 | 0.255 | 99.4% | -0.001 | -0.002 |
| Comparative Example 18 | Green: (Y_{0.99}Ce_{0.01})₃Al₅O₁₂ Red:(Ca_{0.98}Eu_{0.02})AlSiN₃ | 300 mS/cm | 450 nm | 98.6% | 0.269 | 0.254 | 94.7% | -0.025 | +0.003 |

As can be seen from Tables 4 and 5, the light emitting apparatuses of Examples 8 to 18 were excellent in initial brightness and less in brightness reduction and chromaticity variations, as compared with Comparative Examples, which resulted in tremendous improvement in life property.

It should be understood that the embodiments and examples disclosed herein are illustrative and non-restrictive in every respect. The scope of the present invention is defined by the terms of the claims, rather than the description above, and is intended to include any modifications within the scope and meaning equivalent to the terms of the claims.

### REFERENCE SIGNS LIST

1 red light emitting phosphor particle of the present invention, 11 light emitting apparatus, 12 light emitting element, 13 light converter, 14 phosphor particle other than red light emitting phosphor of the present invention, 15 medium.

## Claims

1. A divalent europium-activated nitride red light emitting phosphor substantially represented by
a general formula: (MI₁₋ₓEuₓ)MIISiN₃ (1)
(in the formula (1), MI is an alkaline-earth metal element and represents at least one element selected from the group consisting of Mg, Ca, Sr, and Ba; MII is a trivalent metal element and represents at least one element selected from the group consisting of Al, Ga, In, Sc, Y, La, Gd, and Lu; and x is a number satisfying 0.001 ≤ x ≤ 0.10), wherein
electrical conductivity of a supernatant liquid of a solution containing 10 parts by mass of pure water with respect to 1 part by mass of said red light emitting phosphor is not more than 10 mS/cm.

2. The red light emitting phosphor according to claim 1, wherein, in said general formula (1), MII is at least one element selected from the group consisting of Al, Ga and In.

3. A light emitting apparatus comprising:
a light emitting element of a gallium nitride-based semiconductor emitting primary light having a peak wavelength of 430 to 480 nm; and
a light converter absorbing a part of said primary light and emitting secondary light having a wavelength longer than a wavelength of said primary light, wherein
said light converter is a divalent europium-activated nitride red light emitting phosphor substantially represented by
a general formula:
(MI₁₋ₓEuₓ)MIISiN₃ (1)
(in the formula (1), MI is an alkaline-earth metal element and represents at least one element selected from the group consisting of Mg, Ca, Sr, and Ba; MII is a trivalent metal element and represents at least one element selected from the group consisting of Al, Ga, In, Sc, Y, La, Gd, and Lu; and x is a number satisfying 0.001 ≤ x ≤ 0.10), and
electrical conductivity of a supernatant liquid of a solution containing 10 parts by mass of pure water with respect to 1 part by mass of said red light emitting phosphor is not more than 10 mS/cm.

4. The light emitting apparatus according to claim 3, wherein, in said general formula (1), MII is at least one element selected from the group consisting of Al, Ga and In.

5. The light emitting apparatus according to claim 3, wherein said light converter includes a divalent europium-activated oxynitride green light emitting phosphor which is a β-type SIALON substantially represented by
a general formula: EuₐSi_{b}Al_{c}O_{d}Nₑ (2)
(in the formula (2), a, b, c, d, and e are numbers satisfying 0.005 ≤ a ≤ 0.4, b + c = 12, and d + e = 16).

6. The light emitting apparatus according to claim 3, wherein
said light converter includes at least one of
a trivalent cerium-activated silicate green light emitting phosphor substantially represented by
a general formula: MIII₃(MIV_{1-f}Ce_{f})₂(SiO₄)₃ (3)
(in the formula (3), MIII represents at least one element selected from the group consisting of Mg, Ca, Sr, and Ba; MIV represents at least one element selected from the group consisting of Al, Ga, In, Sc, Y, La, Gd, and Lu; and f is a number satisfying 0.005 ≤ f ≤ 0.5), and
a trivalent cerium-activated oxoate green light emitting phosphor substantially represented by
a general formula: MIII(MIV_{1.f}Ce_{f})₂O₄ (4)
(in the formula (4), MIII represents at least one element selected from the group consisting of Mg, Ca, Sr, and Ba; MIV represents at least one element selected from the group consisting of Al, Ga, In, Sc, Y, La, Gd, and Lu; and f is a number satisfying 0.005 ≤ f ≤ 0.5).

7. The light emitting apparatus according to claim 6, wherein, in said formula (3) or (4), MIV is at least one element of Sc and Y.

8. The light emitting apparatus according to claim 3, wherein said light converter includes at least one of
a divalent europium-activated silicate green light emitting phosphor or yellow light emitting phosphor substantially represented by
a general formula: 2(MV_{1-g}Eu_{g})O·SiO₂ (5)
(in the formula (5), MV represents at least one element selected from the group consisting of Mg, Ca, Sr, and Ba; and g is a number satisfying 0.005 ≤ g ≤ 0.10), and
a trivalent cerium-activated aluminate green light emitting phosphor or yellow light emitting phosphor substantially represented by
a general formula: (MYI₁₋ₕCeₕ)₃Al₅O₁₂ (6)
(in the formula (6), MVI represents at least one element selected from the group consisting of Y, Gd and Lu; and h is a number satisfying 0.005 ≤ h ≤ 0.5).

9. The light emitting apparatus according to claim 8, wherein, in said formula (5), MV is at least one element of Sr and Ba.

10. A method for manufacturing a phosphor, **characterized by** controlling a value of electrical conductivity of a supernatant liquid of a solution containing a phosphor and pure water to be not more than a prescribed value.

11. A method for manufacturing a phosphor, comprising the steps of:
preparing a phosphor; and
cleaning said phosphor using acid and pure water, wherein
said cleaning step is performed until a value of electrical conductivity of a supernatant liquid of a solution containing said phosphor and pure water is not more than a prescribed value.
